(19) **Europäisches Patentamt**

**European Patent Office**

**Office européen des brevets**

(11) **EP 0 878 718 B1**

(12) **EUROPÄISCHE PATENTSCHRIFT**

(45) Veröffentlichungstag und Bekanntmachung des Hinweises auf die Patenterteilung:
**15.09.2004 Patentblatt 2004/38**

(51) Int Cl.7: **G01R 33/34**

(21) Anmeldenummer: **98107241.6**

(22) Anmeldetag: **21.04.1998**

(54) **NMR-Messvorrichtung mit gekühltem Messkopf**

MNR measuring device with cooled probe head

Dispositif de mesure pour la RMN avec tête de mesure refroidie

(84) Benannte Vertragsstaaten:
**CH DE FR GB LI**

(30) Priorität: **16.05.1997 DE 19720677**

(43) Veröffentlichungstag der Anmeldung:
**18.11.1998 Patentblatt 1998/47**

(73) Patentinhaber: **Bruker BioSpin AG**
**8117 Fällanden (CH)**

(72) Erfinder:
• **Triebe, René**
**8051 Zürich (CH)**

• **Marek, Daniel**
**5103 Möriken (CH)**

(74) Vertreter: **KOHLER SCHMID + PARTNER**
**Patentanwälte**
**Ruppmannstrasse 27**
**70565 Stuttgart (DE)**

(56) Entgegenhaltungen:
**EP-A- 0 453 834        EP-A- 0 782 005**
**US-A- 5 508 613**

## Beschreibung

Die Erfindung betrifft eine Messvorrichtung für Kernspinresonanz(NMR)-Messungen mit einem eine oder mehrere NMR-Empfangsspulen enthaltenden NMR-Messkopf, der über eine kryotechnisch isolierte Transferleitung mit Kühlmittel aus einer Kühlvorrichtung versorgt werden kann, wobei die Kühlvorrichtung einen Cryo-Cooler mit einer ersten Kühlstufe mit einem ersten Stufentauscher und mit einer zweiten Kühlstufe mit einem zweiten Stufentauscher aufweist, wobei eine Pumpe vorgesehen ist, die in einen Kreislauf zunächst auf Zimmertemperatur befindliches Kühlmittel durch einen ersten Gegenstromtauscher, den ersten Stufentauscher, einen zweiten Gegenstromtauscher, den zweiten Stufentauscher und die Transferleitung in den NMR-Messkopf zur Kühlung der NMR-Empfangsspule(n) und wieder zurück durch die Transferleitung, den zweiten Gegenstromtauscher und den ersten Gegenstromtauscher fördern kann.

Eine solche NMR-Messvorrichtung ist bekannt aus der US 5,508,613.

Die NMR-Spektroskopie ist eine Messmethode, mit der die Struktur von chemischen Verbindungen sehr genau bestimmt werden kann. Diesem Vorteil steht aber ein grosser Nachteil entgegen: Die NMR-Spektroskopie ist leider auch eine sehr unempfindliche Messmethode, die im allgemeinen nur ein sehr kleines Signal-zu-Rausch-Verhältnis (S/N-Verhältnis) liefert. Es ist deshalb notwendig, alle Möglichkeiten, die zu einer Empfindlichkeitssteigerung führen können, in Betracht zu ziehen.

Durch Optimierung der Geometrie, durch sorgfältige Auswahl der Materialien und durch Benutzung von genau abgestimmten Materialzusammensetzungen für die NMR-Empfangsspule, konnte dieses S/N-Verhältnis beträchtlich verbessert werden. Es zeigt sich jedoch, dass wir heute an die Grenze dieser Optimierungsart gelangt sind, und dass weitere Verbesserungen nur noch in kleinen Schritten zu erwarten sind. Aus diesem Grunde war es notwendig, nach neuen Optimierungsmöglichkeiten zu suchen, auch wenn diese mit einem grösseren apparativen Aufwand verbunden sind. Eine solche Möglichkeit ist die kryogene Kühlung der Empfangsspule mit ihrem elektrischen Resonanz- und Anpassungsnetzwerk. In einem zusätzlichen Schritt muss auch der Vorverstärker gekühlt werden, damit sein Rauschen klein gegenüber dem der Empfangsspule bleibt.

Mit dem Ausdruck "Empfangsspule" sollen nicht nur reine Induktivitäten gemeint sein, sondern auch Resonatoren, die sowohl aus verteilten Induktivitäten wie auch verteilten Kapazitäten zusammengesetzt sind und auf diese Weise ein resonanzfähiges Gebilde im Hochfrequenzbereich darstellen.

Bei den meisten NMR-Messungen wird das S/N-Verhältnis des NMR-Signals am Ausgang des Empfängers in erster Linie durch das S/N-Verhältnis der Empfangsspule limitiert. Dieses S/N-Verhältnis hängt davon ab, wie gross das von einer Standardprobe empfangene NMR-Signal im Vergleich zum Eigenrauschen der Spule ist. Die Grösse des NMR-Signals hängt von der Geometrie der Empfangsspule ab und wie eng die Spule die Messprobe umschliesst. Diese Eigenschaften können durch die Temperatur nicht beeinflusst werden. Anders verhält es sich mit dem Eigenrauschen der Spule, das durch den Hochfrequenzverlustwiderstand $R_{HF}$ der Spule erzeugt wird und erstens von der Grösse seines Widerstandswertes $R_{HF}$ und zweitens von seiner Temperatur T abhängig ist, genauer gesagt von der Wurzel des Produktes $R_{HF} \cdot T$.

Durch eine Abkühlung der Empfangsspule unterhalb 30 K wird sowohl sein Widerstandswert $R_{HF}$ wie auch seine Temperatur T verkleinert, so dass beides zusammen zu einer beträchtlichen Verminderung des Eigenrauschens und zu einer entsprechenden Erhöhung des S/N-Verhältnisses führt.

Aus der eingangs zitierten US 5,508,613 ist eine NMR-Messvorrichtung mit abgekühlter NMR-Empfangsspule bekannt. Ein weiteres, mit der bekannten Vorrichtung nicht gelöstes Problem besteht jedoch im Eigenrauschen des Vorverstärkers, der die aus der NMR-Empfangsspule kommenden NMR-Signale verstärken soll und in der Regel bei Zimmertemperatur arbeitet.

Aufgabe der vorliegenden Erfindung ist es daher, eine NMR-Messvorrichtung der eingangs geschilderten Art vorzustellen, bei der mit möglichst einfachen Mitteln und ohne grossen technischen Aufwand eine erhebliche Rauschverminderung auch beim Vorverstärker erreicht wird.

Erfindungsgemäss wird diese Aufgabe dadurch erfüllt, dass im NMR-Messkopf zusätzlich zu der bzw. den NMR-Empfangsspulen ein oder mehrere Vorverstärker zur Verstärkung der mit den NMR-Empfangsspulen empfangenen NMR-Signale vorhanden sind, dass eine weitere kryotechnisch isolierte Transferleitung zwischen der Kühlvorrichtung und dem NMR-Messkopf vorgesehen ist, über die der bzw. die Vorverstärker und/oder mit den Vorverstärkern in Verbindung stehende Bauteile, z.B. Hochfrequenz(HF)-Schalter, HF-Filter, Befestigungselemente und dergleichen, mit einem Kühlmittelstrom versorgt werden, der sich auf einem höheren Temperaturniveau befindet, als der zur Kühlung der NMR-Empfangsspulen eingesetzte Kühlmittelstrom, und dass zur Kühlung beider Kühlmittelströme ausschliesslich der Cryo-Cooler und ggf. weitere Wärmetauscher vorgesehen sind.

Unter einem "Cryo-Cooler" wird eine Vorrichtung verstanden, die eine Kühlfläche zur Kühlung von Gegenständen zur Verfügung stellt und mit kryogenen Medien betrieben wird, beispielsweise ein Kühler nach Gifford-McMahon, ein Pulse-tube-Cooler oder ein Joule-Thomson-Kühlgerät.

Eine Abkühlung des Vorverstärkers zur Verminderung des Rauschens sollte nicht auf wesentlich unter 80 K erfolgen, da sonst die elektronischen Komponenten, die in Siliziumtechnologie hergestellt sind, ihre Funktionsfähigkeit verlieren. Glücklicherweise ist das Rauschen des Vorverstärkers auch bei dieser etwas erhöhten Temperatur noch so klein, dass es gegenüber dem Rauschen der Empfangsspule nicht mehr dominiert. Vorteilhaft ist daher eine Ausführungsform der erfindungsgemässen Messvorrichtung, bei der der erste Kühlmittelstrom unmittelbar nach Verlassen der NMR-Empfangsspulen eine Temperatur unterhalb 20 K, vorzugsweise um 15 K, und der zweite Kühlmittelstrom unmittelbar nach Verlassen der Vorverstärker eine Temperatur um 80 K, vorzugsweise etwa 77 K aufweist. Dabei können die NMR-Empfangsspulen prinzipiell auch auf niedrigere Temperaturen gekühlt werden, was jedoch einen erheblich höheren technischen Aufwand insbesondere beim Cryo-Cooler erfordern würde, der in keinem vertretbaren Verhältnis zur erzielbaren Verbesserung mehr stehen würde.

Bei einer weiteren Ausführungsform der erfindungsgemässen Messvorrichtung sind zwei getrennte Kühlkreisläufe zur Kühlung der NMR-Empfangsspulen einerseits und zur Kühlung der Vorverstärker und/oder damit in Verbindung stehender Bauteile andererseits vorgesehen. Vorteilhaft bei dieser Ausführungsform ist, dass keine gekühlten Ventile erforderlich sind.

Eine Weiterbildung dieser Ausführungsform sieht vor, dass zusätzlich zum ersten Stufentauscher ein weiterer Stufentauscher an die erste Kühlstufe des Cryo-Coolers angeschlossen ist, wobei der erste Stufentauscher zur Kühlung des Kühlmittelstroms im Kühlkreislauf der NMR-Empfangsspulen und der weitere Stufentauscher im Kühlkreislauf der Vorverstärker eingesetzt ist. Durch die Anordnung eines weiteren Stufentauschers an der ersten Kühlstufe ergibt sich eine räumlich kompakte Lösung.

Bei einer Weiterbildung dieser Ausführungsform ist ein weiterer Gegenstromtauscher zwischen der Pumpe und dem weiteren Stufentauscher sowie der weiteren Transferleitung in den Kühlkreislauf des Vorverstärkers zur Erhöhung der thermischen Effizienz geschaltet. Dadurch wird eine Trennung der beiden Temperaturbereiche von etwa 300 K und ungefähr 80 K ohne nennenswerte thermische Verluste erreicht.

Vorteilhaft ist auch eine Weiterbildung, bei der in beiden Kühlkreisläufen jeweils mindestens ein auf ungefähr Raumtemperatur befindliches Ventil zur Steuerung der Massenflüsse des Kühlmittels vorgesehen ist. Das Raumtemperatur-Ventil dient der Feinoptimierung der Kühlmittelflüsse und damit der Temperaturverteilungen in den beiden Kühlkreisläufen.

Besonders bevorzugt ist eine Ausführungsform der erfindungsgemässen Messvorrichtung, bei der lediglich ein einziger Kühlkreislauf mit zwei Teilströmen zur Kühlung der NMR-Empfangsspulen einerseits und zur Kühlung der Vorverstärker und/oder damit in Verbindung stehender Bauteile andererseits vorgesehen ist. Gegenüber der oben geschilderten Ausführungsform mit zwei getrennten Kühlkreisläufen sind hierbei weniger teure Cryo-Bauteile erforderlich, da zumindest ein Gegenstromtauscher als Kältepuffer für den zweiten Kühlkreislauf wegfällt.

Bei einer vorteilhaften Weiterbildung dieser Ausführungsform ist ein gekühltes Ventil zur Steuerung des Massenflusses des zu den Vorverstärkern strömenden Kühlmittels vorgesehen. Damit lassen sich die beiden Teilströme des Kühlmittelkreislaufs feinoptimieren und insbesondere die Temperatur an den Vorverstärkern empfindlich einstellen, was deren Betriebssicherheit dient, da sie nur bis herunter zu einer Temperatur von ca. 80 K noch zuverlässig und rauschoptimiert arbeiten.

Bei einer besonders bevorzugten Weiterbildung ist vorgesehen, dass zusätzlich zum ersten Stufentauscher ein weiterer Stufentauscher an die erste Kühlstufe des Cryo-Coolers angeschlossen ist, wobei der weitere Stufentauscher zur Kühlung der Vorverstärker und/oder damit in Verbindung stehender Bauteile und gegebenenfalls eines zum ersten Stufentauscher direkt strömenden Teilstroms von Kühlmittel und der erste Stufentauscher zur Kühlung des zu den NMR-Empfangsspulen strömenden Kühlmittels eingesetzt ist. Durch den weiteren Stufentauscher wird eine erste Vorkühlung des Kühlmittels bewirkt. Das in den Vorverstärkern erwärmte Kühlmittel wird dann nochmals zur ersten Stufe des Cryo-Coolers geführt und mit dem ersten Stufentauscher abgekühlt, wodurch eine Verbesserung der Kühleffizienz des zweiten Gegenstromtauschers und damit eine Verringerung der Belastung der zweiten Kühlstufe des Cryo-Coolers erreicht wird.

Bei einer alternativen Weiterbildung der oben beschriebenen Ausführungsform wird ein Teilstrom des von den NMR-Empfangsspulen über den zweiten Gegenstromtauscher zurückströmenden Kühlmittels zur Kühlung der Vorverstärker und/oder damit in Verbindung stehender Bauteile abgezweigt und anschliessend durch die weitere Transferleitung und den ersten Gegenstromtauscher zur Pumpe zurückgeführt. Damit lassen sich gegenüber den übrigen geschilderten Ausführungsformen der erfindungsgemässen Messvorrichtung die niedrigsten Temperaturen an den NMR-Empfangsspulen erreichen, da die Kühleffizienz bei dieser Variante am höchsten ist.

Alternativ dazu kann aber auch der gesamte Kühlmittelstrom von den NMR-Empfangsspulen über den zweiten Gegenstromtauscher zur Kühlung der Vorverstärker und/oder damit in Verbindung stehender Bauteile und anschliessend durch die weitere Transferleitung und den ersten Gegenstromtauscher zur Pumpe geführt werden. Diese Lösung ist technisch die einfachste und kompakteste bei gleichwohl hoher Effizienz. Ein gekühltes Ventil ist hierbei nicht erforderlich.

Bei einer weiteren Ausführungsform der erfindungsgemässen Messvorrichtung ist in räumlicher Nähe der Vorverstärker ein Heizer vorgesehen, mit dem auf einfache Weise eine direkte Temperatursteuerung der Vorverstärker vorgenommen werden kann.

Vorteilhaft ist auch eine Ausführungsform, bei der eine gemeinsame kryotechnische Isolation um die erste Transferleitung und die weitere Transferleitung vorgesehen ist. Durch die räumliche Nähe der beiden Transferleitungen und die gemeinsame kryotechnische Isolierung wird die Anordnung besonders kompakt und etwaige Wärmeverluste an den Transferleitungen verringert.

Weitere Vorteile der Erfindung ergeben sich aus der Beschreibung und der Zeichnung. Die gezeigten und beschriebenen Ausführungsformen sind nicht als abschliessende Aufzählung zu verstehen, sondern haben vielmehr beispielhaften Charakter für die Schilderung der Erfindung.

Die Erfindung ist in der Zeichnung dargestellt und wird anhand eines Ausführungsbeispiels näher erläutert. Es zeigen:

Fig. 1     eine erste Ausführungsform der erfindungsgemässen Messvorrichtung mit zwei getrennten Kühlkreisläufen;

Fig. 2     eine Ausführungsform der Erfindung mit einem einzigen Kühlkreislauf;

Fig. 3a    eine weitere Ausführungsform mit einem einzigen Kühlkreislauf, jedoch ohne zusätzlichen Stufentauscher;

Fig. 3b    eine Ausführungsform wie in Fig. 3a, jedoch ohne gekühltes Ventil;

Fig. 4     eine einfache NMR-Messvorrichtung mit gekühlten Empfangsspulen nach dem Stand der Technik;

Fig. 5     eine NMR-Messvorrichtung nach dem Stand der Technik gemäss US 5,508,613 mit verbesserter Effizienz gegenüber der in Fig. 4 gezeigten, bekannten Vorrichtung; und

Fig. 6     eine nicht erfindungsgemäße NMR-Messvorrichtung mit Möglichkeit der Kühlung der NMR-Empfangsspulen und mit gesonderter Kühlvorrichtung zur Kühlung der Vorverstärker.

Es ist vorteilhaft, wenn eine zusätzliche gekühlte Masse mit einer Temperatur zwischen 300 K und der Temperatur der Empfangsspule zur Verfügung steht, denn diese kann als Stütze für eine Befestigung der Empfangsspule benutzt werden. Dadurch erübrigt sich eine Abstützung auf Komponenten bei Zimmertemperatur, und man erreicht eine erhebliche Verminderung des Wärmezuflusses über die Befestigungsstruktur der Empfangsspule. Als Folge davon können solidere Befestigungen und Zuleitungen eingesetzt werden, ohne dass dabei der Wärmezufluss zu gross wird. Die gekühlte Masse lässt sich z.B. mit Hilfe der ersten Stufe eines zweistufigen Cryo-Coolers kühl halten.

Die Kühlung einer Empfangsspule in den Bereich unterhalb 30 K ist nicht einfach, weil die Spule thermisch nicht sehr wirkungsvoll isoliert werden kann. Die Spule sollte nämlich aus Empfindlichkeitsgründen die Messprobe relativ eng umschliessen, letztere wiederum sollte aber auf Zimmertemperatur bleiben. Die Spule wird somit von der Messprobe und ihrer auf Zimmertemperatur befindlichen Umgebung stark mit Wärme bestrahlt, und der so entstehende Wärmefluss muss von der Kühlvorrichtung aufgenommen werden.

Zur Kühlung der Empfangsspule und des Vorverstärkers kann flüssiges Helium verwendet werden, was aber mit einem erheblichen Kostenaufwand verbunden ist, da infolge der grossen Wärmeeinstrahlung der Messprobe und ihrer Umgebung grössere Mengen an flüssigem Helium, das sehr teuer ist, verbraucht werden. Zweckmässiger ist die Verwendung eines aktiven Cryo-Coolers. Am wirkungsvollsten wäre es, diesen Cryo-Cooler möglichst nahe beim NMR-Messkopf anzubringen, was aber erstens aus Platzgründen kaum realisierbar ist, und zweitens aus mechanischen Gründen problematisch wäre, weil mechanische Vibrationen des Cryo-Coolers sich sehr leicht auf die Empfangsspule übertragen könnten. Es ist deshalb vorteilhaft, die Kühlleistung nicht direkt an die zu kühlenden Objekte abzugeben, sondern zuerst an strömendes Heliumgas, das als Träger und Transportmittel der Kühlleistung dient. Der Transfer der Kühlleistung vom Cryo-Cooler zum Heliumgas lässt sich über Stufen-Wärmetauscher realisieren, und der weitere Transfer vom Wärmetauscher zu den zu kühlenden Objekten über Transferleitungen mit interner Hochvakuumisolation.

Bei den heute kommerziell und standardmässig erhältlichen Cryo-Coolern stösst man auf ein generelles Problem: Die zur Verfügung stehende Kühlleistung bei Temperaturen um 10 K liegt bestenfalls bei ca. 6 Watt. Höhere Kühlleistungen (z.B. 10 W und darüber) sind grundsätzlich möglich, führen aber zu einem derart hohen finanziellen Aufwand, dass sie für kommerzielle Anwendungen in der NMR nicht in Frage kommen. Es ist deshalb unumgänglich, dass die Kühlvorrichtung sehr stark optimiert werden muss, damit die beschränkte Kühlleistung möglichst vollständig an den Ort der zu kühlenden Objekte gelangt. Die Gestaltung solcher Kühlvorrichtungen verlangt ein hohes Mass an Know-how und ist Gegenstand der vorliegenden Erfindung.

Damit die Kühlleistung weitergeleitet werden kann, muss das Heliumgas mit Hilfe einer Pumpe umgewälzt werden. Die einfachste Lösung wäre, diese Pumpe auf den gewünschten tiefen Temperaturen zu betreiben. Dies würde jedoch bedeuten, dass bewegte mechanische Teile bei tiefsten Temperaturen und über längere Zeit zuverlässig arbeiten müssten, was bereits sehr problematisch ist, und auch die Wartung einer solchen Pumpe wäre mit grösserem Aufwand verbunden. Zudem erzeugt eine solche Pumpe auch Wärme und belastet deshalb zusätzlich die Effizienz der Kühlung.

Es ist deshalb zweckmässiger, die Pumpe bei Zimmertemperatur zu betreiben. Das heisst aber, dass das Heliumgas, das die zu kühlenden Objekte verlässt und immer noch sehr kalt ist, zuerst wieder erwärmt werden muss, bevor es der Pumpe wieder zugeführt werden kann. Bei diesem Erwärmungsprozess wird dem Heliumgas sehr viel Kühlleistung entnommen, die normalerweise verloren ginge, wenn nicht spezielle Massnahmen getroffen würden. Anstatt diese Kühlleistung ungenützt an irgend ein Medium abzugeben, wird diese gezielt zur Abkühlung des wärmeren Heliumgases im Innern der Kühlvorrichtung benützt. Insbesondere kann das noch kalte Heliumgas, das von der Kühlvorrichtung zurück zur Pumpe geführt werden muss, vorher dazu benutzt werden, das warme Gas, das von der Pumpe in die Kühlvorrichtung fliesst, vorzukühlen. Im Idealfall besitzen dann das eintretende und austretende Heliumgas der Pumpe dieselbe Temperatur. Die Übertragung der Kühlleistung erfolgt über sogenannte Gegenstrom-Wärmetauscher.

Normalerweise werden bei Kühlvorrichtungen zwei verschiedene Arten von Wärmetauschern eingesetzt, der Stufentauscher mit einer einzigen Gasleitung, und der Gegenstromtauscher mit zwei Gasleitungen.

Der Stufentauscher benötigt einen direkten thermischen Anschluss an eine Kältequelle (z.B. eine der Kühlstufen eines Cryo-Coolers) und kühlt das aus dem Wärmetauscher austretende Gas hinunter auf die Temperatur der Kältequelle. Die Effizienz dieses Wärmetauschers ist am grössten, wenn das austretende Gas genau die Temperatur der Kältequelle annimmt. Diese ideale Effizienz wird in der Praxis auch tatsächlich erreicht!

Der Gegenstromtauscher ist etwas kritischer und zeigt normalerweise immer einen Effizienzverlust. Er erzeugt einen Wärmeaustausch zwischen zwei entgegengesetzt fliessenden Gasströmen mit unterschiedlichen Temperaturen und erreicht dies durch eine enge thermische Verbindung der beiden Gasleitungen. Die maximal übertragbare Kühlleistung ist durch die Temperaturdifferenz zwischen dem wärmeren ($T = T_{warm}$) und dem kälteren ($T = T_{kalt}$) Ende des Wärmetauschers gegeben. Die Effizienz des Gegenstromtauschers hängt davon ab, wieviel von der maximal übertragbaren Kühlleistung tatsächlich vom kälteren Gas zum wärmeren Gas übertragen wird. Sie ist am grössten, wenn die Temperaturdifferenz $\Delta T$ der beiden Gasströme, gemessen jeweils an den beiden Enden des Wärmetauschers, Null ist. Tritt ein endlicher Wert $\Delta T$ auf, so ist dieser Wert, im Vergleich zur Temperaturdifferenz ($T_{warm} - T_{kalt}$) über dem Wärmetauscher, ein Mass für die Ineffizienz des Wärmetauschers und kann durch den Ineffizienzfaktor $k_{ineff}$ erfasst werden:

$$k_{ineff} = \Delta T / (T_{warm} - T_{kalt})$$

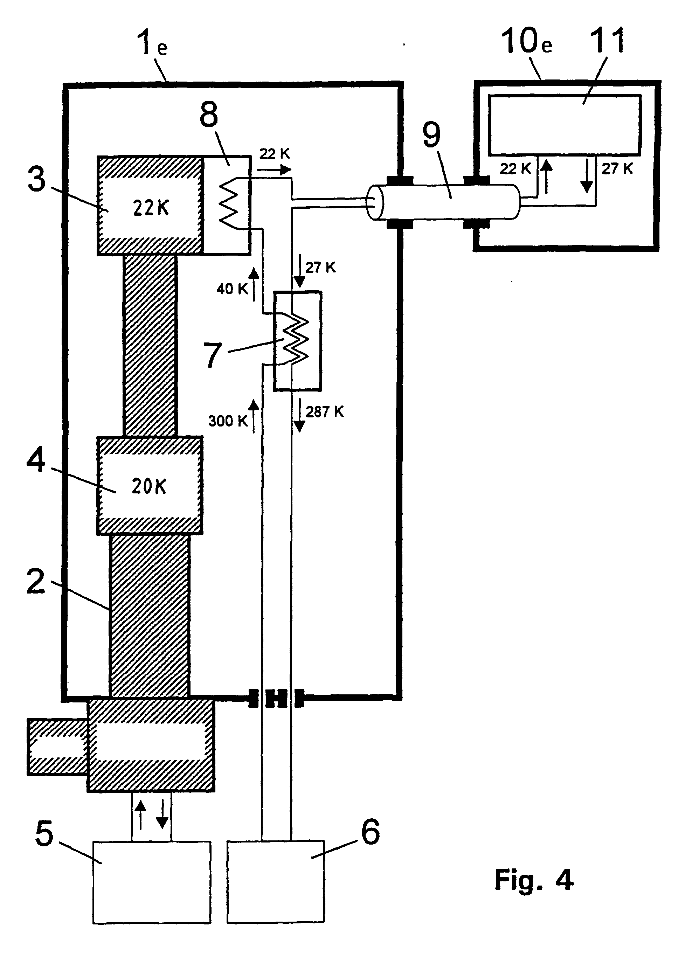

In der Praxis kann bei einem guten Aufbau verbunden mit einem angemessenen Aufwand ein Ineffizienzfaktor von 5 % erreicht werden. Betrachten wir den in Fig. 4 dargestellten, bekannten Gegenstromtauscher, so gilt dort $\Delta T$ = 13 K und ($T_{warm} - T_{kalt}$) = 260 K. Damit beträgt der Ineffizienzfaktor 5 %.

Infolge der Ineffizienz geht etwas Kühlleistung verloren, die stets von der Kühlstufe, die am kälteren Ende des Gegenstromtauscher angeschlossen ist, abgezogen werden muss. In Fig. 4 ist dies die 2. Stufe des Cryo-Coolers.

Gegenstromtauscher kommen dann zum Einsatz, wenn die Temperatur eines kalten Gasstromes erhöht werden muss und dabei möglichst wenig von der im Gas enthaltenen Kühlenergie (physikalisch durch die Enthalpie definiert) verloren gehen soll. Der Gegenstromtauscher löst dieses Problem, indem er die im kälteren Gasstrom enthaltene Kühlenergie auf das wärmere Gas überträgt. Betrachtet man in Fig. 4 den bekannten Gegenstromtauscher, so sieht man, dass der kalte Gasstrom von 27 K auf 287 K erwärmt, und im Gegenzug der warme Gasstrom von 300 K auf 40 K abgekühlt wird. Infolge der Ineffizienz des Wärmetauschers entsteht eine Differenz von 13 K zwischen den beiden Gasströmen, die ungenutzt verloren geht und die zweite Stufe belastet.

Verschiedene Massnahmen müssen beachtet werden, um die Wärmeverluste einer Kühlvorrichtung möglichst klein zu halten:

1. Alle rückfliessenden kälteren Gasströme müssen dazu benutzt werden, die zufliessenden wärmeren Gasströme vorzukühlen. Auf diese Weise erreicht man beispielsweise, dass die Temperatur des Heliumgases, das zurück in die Pumpe fliesst, fast gleich gross ist wie die des Gases, das von der Pumpe in die Kühlvorrichtung fliesst.

2. Die Stufentauscher sollten die ideale Effizienz von 100 % erreichen, so dass die ganze Kühlleistung des Cryo-Coolers an das Heliumgas übertragen wird.

3. Die Gegenstromtauscher sollten einen möglichst kleinen Ineffizienzfaktor besitzen, damit sie die Kühlstufen des Cryo-Coolers nicht unnötigerweise belasten.

4. Die Anzahl der Komponenten innerhalb der Kühlvorrichtung sollte minimiert werden, da jede dieser Komponenten Kühlverluste verursachen kann.

5. Die Massenflüsse des Heliumgases müssen sorgfältig optimiert sein.

6. Die Transferleitungen, mit denen das kalte Heliumgas zu den zu kühlenden Objekten befördert wird, sollten möglichst geringe Wärmeverluste erzeugen.

Um verschiedene Kühlvorrichtungen miteinander vergleichen zu können, müssen einige Annahmen festgelegt werden, die für alle Kühlvorrichtungen gelten sollen:

1. Der Massenfluss des Heliumgases zur Empfangsspule soll mit 55 Normliter/Min angenommen werden. Dies führt zu einer Transportleistung des Heliumgases von 1 Watt/K.

2. Es soll ein kommerziell erhältlicher zweistufiger Cryo-Cooler angenommen werden, und die Kennlinien seiner beiden Kühlstufen durch vereinfachte Gleichungen, die aber die reellen Kennlinien ziemlich genau darstellen, approximiert werden. Diese Gleichungen lauten:

$$\text{Erste Stufe: } T_1(P_1) = 20 \text{ K} + P_1 \cdot 0{,}5 \text{ K/Watt}$$

$$\text{Zweite Stufe: } T_2(P_2) = 4 \text{ K} + P2 \cdot 1{,}0 \text{ K/Watt}$$

$T_1$ und $T_2$ sind die Temperaturen, die sich an den beiden Kühlstufen einstellen, wenn diese eine Kühlleistung von $P_1$ resp. $P_2$ abgeben.

3. Alle Stufentauscher sollen eine ideale Effizienz aufweisen.

4. Alle Gegenstromtauscher sollen einen Inefizienzfaktor von 5 % besitzen. Das führt zu einer Temperaturdifferenz $\Delta T$ zwischen den beiden Enden des Tauschers von $\Delta T = 0{,}05 \cdot (T_{warm} - T_{kalt})$ und, wenn man den Normfluss von 55 Normliter/Min ( = 1 Watt/K Transportleistung) annimmt, zu einer Belastung $\Delta Pt$ der Kältestufe an der kälteren Seite des Tauschers von $\Delta Pt = (T_{warm} - T_{kalt}) \cdot 0.05 \text{ Watt/K}$.

5. Im Bereich der Empfangsspule soll eine Wärmeeinstrahlung von 5 W vorhanden sein.

6. Der Vorverstärker soll auf einer Temperatur von 77 K arbeiten.

7. Der Vorverstärker mit seiner Elektronik soll 20 W Wärme erzeugen. Durch einen zusätzlichen Heizer am Vorverstärker Gehäuse, oder durch ein By-Pass-Ventil, das den Massenstrom des Heliumgases zum Vorverstärker verkleinert, soll die gewünschte Temperatur von 77 K eingehalten werden.

Bei den nachfolgenden Beschreibungen und Erklärungen werden die oben getroffenen Annahmen zu Grunde gelegt. Dies bedeutet, dass die angegebenen Temperaturen und Massenflüsse nur Beispiele sind, die aus diesen Annahmen resultieren, dass aber auch andere Temperaturen und Massenflüsse möglich sind.

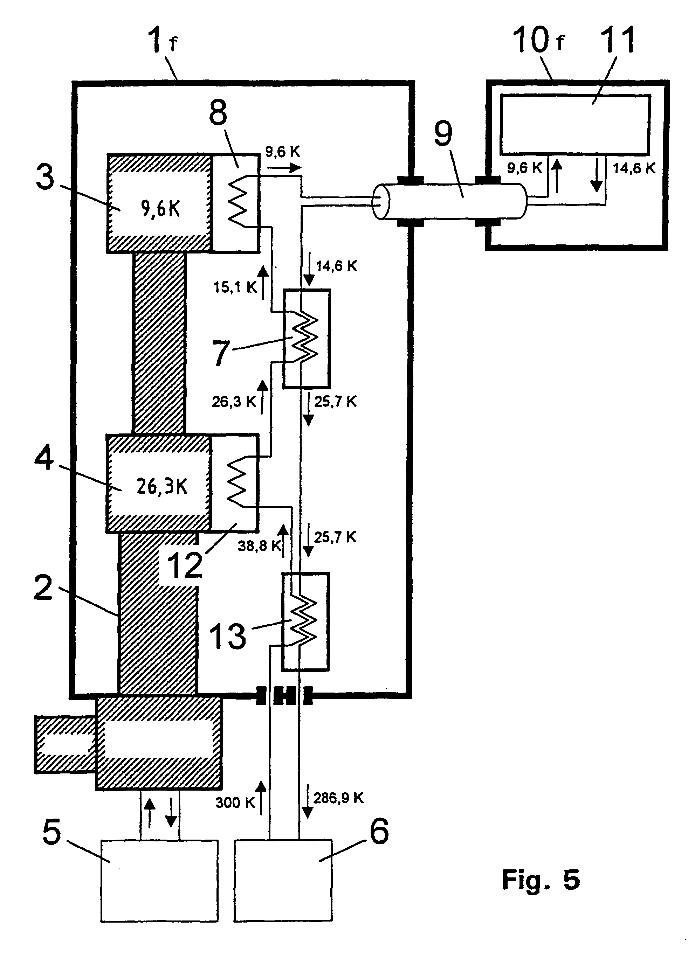

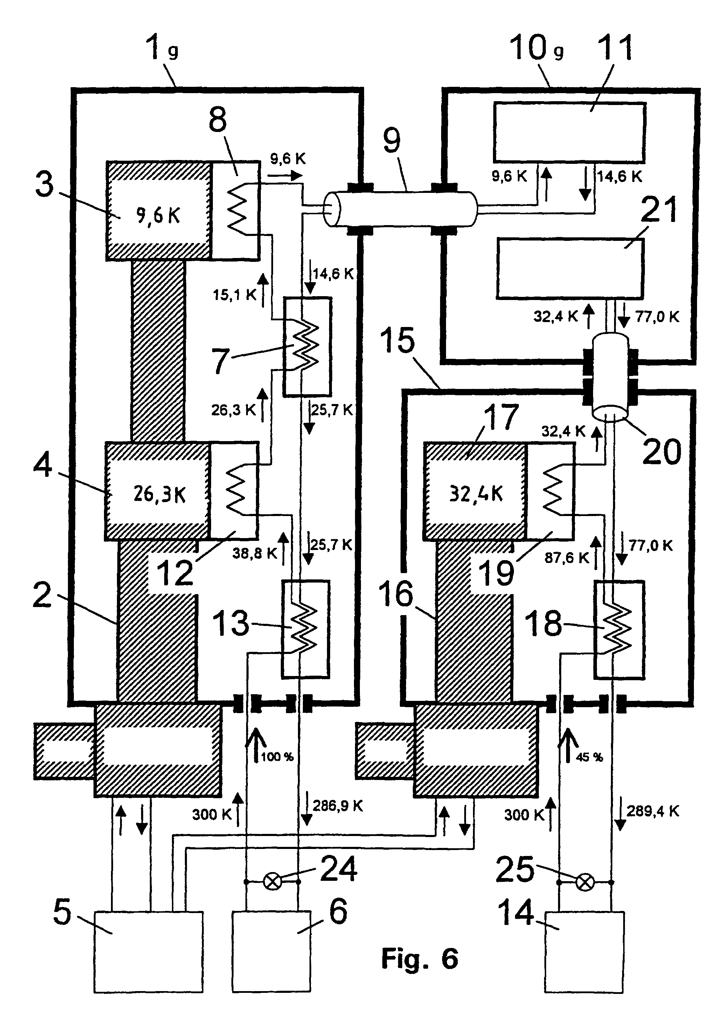

Der gegenwärtige Stand der Technik für Kryo-Vorrichtungen zur Kühlung von NMR-Empfangsspulen ist in Fig. 4 und Fig. 5 dargestellt. Beide Kühlvorrichtungen erlauben eine Abkühlung der Empfangsspule auf eine Temperatur unterhalb 30 K. Eine demgegenüber verbesserte, jedoch kein Ausführungsbeispiel der Erfindung darstellende Anordnung, bei der sowohl die Empfangsspule wie auch der Vorverstärker auf jeweils unterschiedliche Temperaturen abgekühlt werden können, ist in Fig. 6 dargestellt.

In Fig. 4 ist die einfachste Variante dargestellt. Sie besteht aus einer Kühlvorrichtung 1e, deren Innenteil evakuiert ist, um thermische Verluste infolge Wärmeleitung über die Luft zu vermeiden. Die Kühlung erfolgt durch einen Cryo-Cooler 2, der über Gasleitungen mit einem Kompressor 5 verbunden und aus einer ersten Kühlstufe 4 auf 20 K und einer zweiten Kühlstufe 3 auf 22 K zusammengesetzt ist. Beide Stufen stellen Kältequellen dar und besitzen thermische Anzapfungsflächen, an die Einzelteile angeschlossen und gekühlt werden können. Ein solches Einzelteil ist ein Stufentauscher 8, der an die zweite Kühlstufe 3 des Cryo-Coolers 2 angeschlossen ist.

Die Pumpe 6 ist eine Umwälzpumpe, die das Heliumgas in einem geschlossenen Kreislauf umwälzt. Das Heliumgas tritt mit Zimmertemperatur (300 K) von der Pumpe in die Kühlvorrichtung ein, wo sie durch einen Gegenstromtauscher 7 auf 40 K vorgekühlt wird. Anschliessend wird das Heliumgas im Stufentauscher 8, der an die zweite Stufe 3 des Cryo-Coolers angeschlossen ist, auf 22 K gekühlt. Dieses Heliumgas wird über eine Transferleitung 9 einer Empfangsspule 11 in einem NMR-Messkopf 10e zugeführt, wodurch die Empfangsspule 11 auf 27 K gekühlt wird. Das Heliumgas erwärmt sich dabei auf 27 K und tritt durch die Transferleitung 9 wieder in die Kühlvorrichtung 1e zurück. Dort gelangt es wieder in den Gegenstromtauscher 7, wo es auf 287 K aufgewärmt wird und praktisch mit Zimmertemperatur wieder zur Pumpe gelangt.

In Fig. 5 ist ebenfalls eine bekannte Anordnung (entspricht ungefähr dem US-Patent 5,508,613) dargestellt, die eine verbesserte Effizienz besitzt. Der Cryo-Cooler 2 der Kühlvorrichtung 1f besitzt neben der zweiten Kühlstufe 3 auch eine erste Stufe 4 zur Kühlung des Heliumgases und benötigt dazu zwei Gegenstromtauscher 13 und 7. Durch die Verteilung des gesamten Temperaturbereiches auf zwei Gegenstromtauscher erreicht man, dass die kritische zweite Stufe 3 nur die Belastung $\Delta T = 0,5$ K des Gegenstromtauschers 7 zu tragen hat, die viel grössere Belastung $\Delta T = 13,1$ K des Gegenstromtauschers 13 hingegen von der ersten Stufe übernommen wird. Dadurch kann die zweite Stufe 3 kühleres Gas, d.h. mehr Kühlleistung an die Empfangsspule 11 im NMR-Messkopf 10f liefern.

Das eintretende Heliumgas, das Zimmertemperatur besitzt, wird zuerst mit Hilfe des ersten Gegenstromtauschers 13 auf 38,8 K und dann in einem Stufentauscher 12 der ersten Stufe 4 des Cryo-Coolers 2 auf 26,3 K vorgekühlt, bevor es zum zweiten Gegenstromtauscher 7 gelangt. Dort wird das Heliumgas auf 15,1 K und im anschliessenden Stufentauscher 8 der zweiten Stufe 3 auf die Endtemperatur von 9,6 K gekühlt. Dieses kalte Gas wird über die Transferleitung 9 der Empfangsspule 11 zugeführt, wodurch diese auf 14,6 K hinunter gekühlt wird. Anschliessend gelangt das auf 14,6 K aufgewärmte Gas wieder über die Transferleitung 9 in die Kühlvorrichtung 1f und über die Gegenstromtauscher 7 und 13 zurück zur Pumpe 6. Das eintretende und austretende Heliumgas an der Pumpe 6 besitzen annähernd gleiche Temperaturen, was auf eine gute Ausnützung der Kälteleistung des Gases schliessen lässt.

Fig. 6 stellt eine nicht erfindungsgemässe Kühlvorrichtung dar, die sowohl die Empfangsspule 11 wie auch einen Vorverstärker 21 im NMR-Messkopf 10g abzukühlen vermag, und zwar auf zwei verschiedene Temperaturbereiche, nämlich kleiner 20 K und ca. 77 K. Dazu werden zwei Cryo-Cooler 2 und 16 und zwei getrennte Kühlkreisläufe benutzt, einen ersten für die Empfangsspule und angetrieben durch die Pumpe 6, einen zweiten für den Vorverstärker und angetrieben durch eine Pumpe 14. Der erste Kühlkreislauf wird durch die bereits bekannte Kühlvorrichtung von Fig. 5 gekühlt und weist einen Normfluss von 55 Normalliter/Min auf, der mit einem Ventil 24 eingestellt wird und in Fig. 6 mit 100 % bezeichnet ist. Der zweite Kühlkreislauf wird nur durch einen einstufigen Cryo-Cooler 16 gekühlt, und sein Massenfluss wird mit einem Ventil 25 so eingestellt, dass der Vorverstärkers 21 die gewünschte Temperatur von 77 K erreicht. Der dazu benötigte Massenfluss beträgt dann 45 % des Normflusses und ist ebenfalls in Fig. 6 eingetragen.

Die Kühlvorrichtung 1g ist identisch mit der in Fig. 5 beschriebenen bekannten Vorrichtung und bedarf keiner weiteren Erläuterungen. Bei der zusätzlichen Kühlvorrichtung 15 in Fig. 6 wird das Heliumgas, das die Pumpe 14 mit Zimmertemperatur verlässt, in einem Gegenstromtauscher 18 auf 87,6 K vorgekühlt und anschliessend in einem Stufentauscher 19, der mit der ersten und einzigen Kühlstufe 17 des Cryo-Coolers 16 verbunden ist, auf 32,4 K gekühlt. Das so gekühlte Heliumgas gelangt über eine Transferleitung 20 in den NMR-Messkopf 10g und zum Vorverstärker 21, der auf 77 K abgekühlt wird. Dadurch erwärmt sich das Gas von 32,4 K auf 77 K und gelangt zurück in die Kühlvorrichtung 15, wo es die in ihm noch vorhandene Kühlenergie über den Gegenstromtauscher 18 an das zufliessende warme Heliumgas aus der Pumpe 14 abgibt und anschliessend mit nahezu Zimmertemperatur, d.h. mit 289,4 K zurück in die Pumpe 14 fliesst.

In der NMR sind im Bereich der Messprobe normalerweise zwei orthogonal zueinander angeordnete Spulensysteme oder Resonatoren eingebaut, die sowohl der Anregung des Spinsystems wie auch dem Empfang des NMR-Signals dienen können. Beide Spulensysteme oder Resonatoren sind normalerweise auf unterschiedliche Kernarten abgestimmt, z.B. das eine Spulensystem auf Protonen $^1$H und das andere auf Phosphor [31]P. Zudem kann jedes der beiden Spulensysteme oder Resonatoren auf zwei oder mehr Kernarten zugleich abgestimmt sein, was eine Vielfalt von Messmöglichkeiten erlaubt. Wenn in der weiteren Beschreibung von einer Empfangsspule 11 die Rede ist, dann sind damit solche Spulensysteme oder Resonatoren gemeint, wie sie soeben beschrieben wurden.

Entsprechend obiger Beschreibung können NMR-Signale von mehreren Kernarten zugleich empfangen werden. Diese NMR-Signale liegen im allgemeinen in verschiedenen Frequenzbereichen und benötigen deshalb verschiedene Vorverstärker. Wenn also in der weiteren Beschreibung von einem Vorverstärker 21 die Rede ist, dann sollen damit auch mehrere Vorverstärker zugleich gemeint sein.

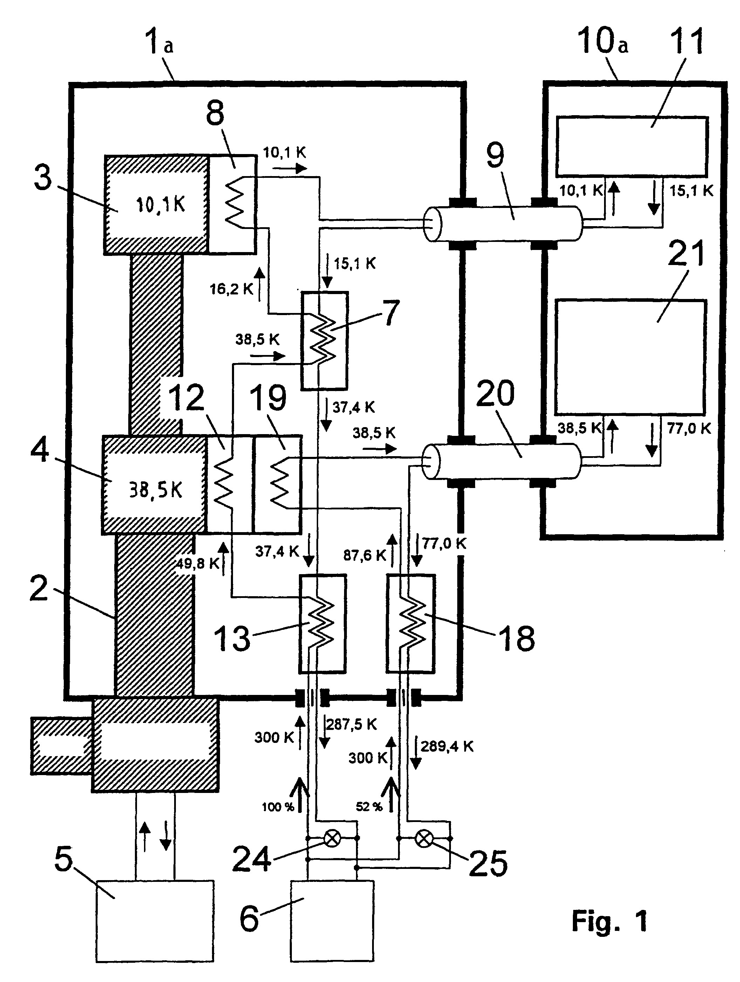

Die erfindungsgemässen Kühlvorrichtungen sind in den Figuren 1, 2 und 3a/3b dargestellt. Alle drei Vorrichtungen haben mehrere Merkmale gemeinsam:

1. Sie benutzen einen einzigen, zweistufigen Cryo-Cooler, um sämtliche Kühlaufgaben zu lösen.

2. Sie sind so aufgebaut, dass sie gleichzeitig zwei Objekte, nämlich die NMR-Empfangsspule und den dazu gehörenden Vorverstärker, kühlen können und zwar jedes Objekt auf eine verschiedene Temperatur.

3. Sie besitzen einen praktisch identischen Aufbau, um die Empfangsspule mit der zweiten Stufe des Cryo-Coolers zu verbinden, und um die noch verbleibende Kühlleistung des zurückfliessenden Gases in einem Gegenstromtauscher an das zufliessende Gas abzugeben.

Die drei Vorrichtungen unterscheiden sich im wesentlichen durch die Art und Weise, wie die Vorverstärker auf die Temperatur von 77 K gekühlt werden.

Die erste Vorrichtung ist in Fig. 1 dargestellt. Sie verwendet zur Kühlung des Vorverstärkers 21 einen zweiten, getrennten Heliumgaskreislauf. Der erste Kreislauf dient der Kühlung der Empfangsspule 11 und wird durch die Pumpe 6 angetrieben. Der zweite wird ebenfalls durch die Pumpe 6 angetrieben und kühlt den Vorverstärker 21. Im Unterschied zur Kühlvorrichtung von Fig. 6, dient hier die erste Kühlstufe 4 des Cryo-Coolers 2 nicht nur der Kühlung des ersten Kreislaufes, sondern zugleich auch des zweiten. Auf diese Weise ist es möglich, nur mit einem einzigen Cryo-Cooler 2 auszukommen und, im Vergleich zu Fig. 6, mit viel weniger apparativem Aufwand. Die Beschreibung des ersten Kreislaufes lässt sich der Beschreibung von Fig. 5 entnehmen, die des zweiten Kreislaufes jener von Fig. 6.

Eine individuelle Einstellung des Gasflusses in den beiden Kreisläufen ist für einen effizienten Kühlbetrieb unumgänglich. Sie erfolgt mit Hilfe der beiden Ventile 24 und 25, die sich ausserhalb der Kühlvorrichtung 1a im Bereich der Pumpe 6 befinden. Mit dem ersten Ventil 24 wird der Normfluss eingestellt (in Fig. 1 mit 100 % bezeichnet, damit die früher aufgestellten Vergleichsannahmen erfüllt sind). Das zweite Ventil 25 ist viel wichtiger, denn mit ihm wird der Massenfluss des zweiten Kreislaufes so eingestellt, dass der Vorverstärker auf die gewünschte Temperatur von 77 K kommt. Dazu wird 52 % des Normflusses benötigt, wie dies in Fig. 1 angedeutet ist.

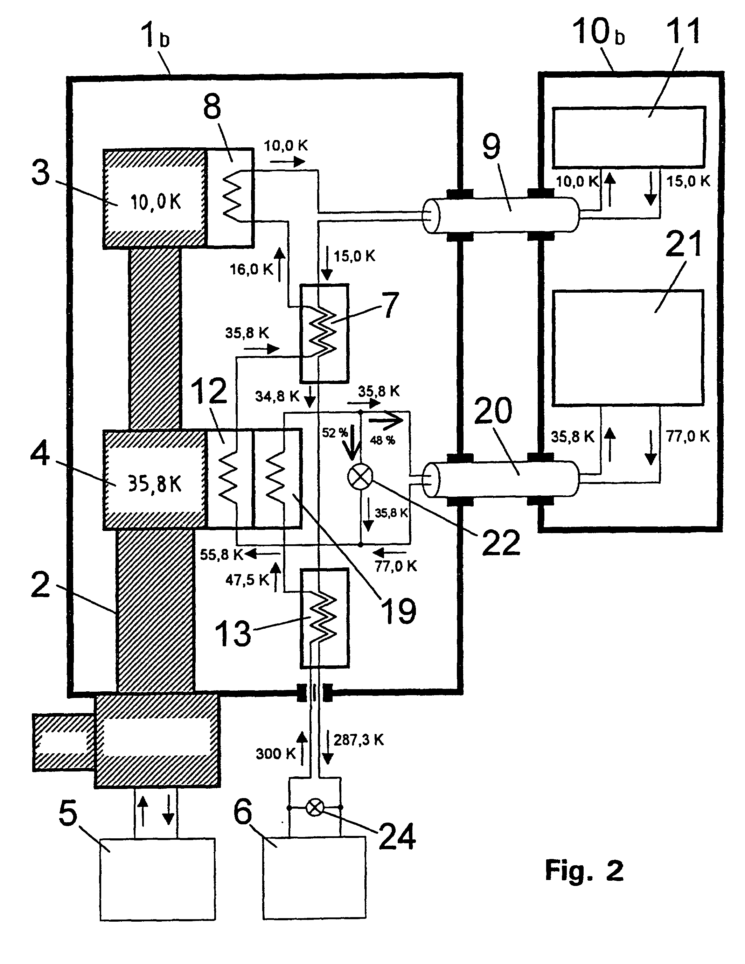

Bei der zweiten Vorrichtung, dargestellt in Fig. 2, wird nur ein einziger Heliumgaskreislauf benötigt, der von der Pumpe 6 angetrieben wird und sowohl der Kühlung der Empfangsspule 11 wie auch des Vorverstärkers 21 dient. Erreicht wird dies dadurch, dass die Verbindung vom Gegenstromtauscher 13 zum Stufentauscher 12 unterbrochen und dazwischen die Kühlung des Vorverstärkers 21 geschaltet wird. Das Heliumgas aus dem Gegenstromtauscher 13 gelangt zuerst zum Stufentauscher 19, wo es von 47,5 K auf 35.8 K gekühlt wird. Das Ventil 22 ist so eingestellt, dass genau die Menge Gas zum Vorverstärker 21 gelangt, die zur Kühlung des Vorverstärkers 21 auf die gewünschte Temperatur von 77 K benötigt wird. Diese Gasmenge beträgt 48 % des Gesamtflusses. Die restlichen 52 % gelangen direkt über das Ventil 22 zum zweiten Stufentauscher 12. Der Gasanteil von 48 % gelangt über die Transferleitung 20 in den NMR-Messkopf 10b, kühlt dort den Vorverstärker 21 genau auf 77 K und erwärmt sich dabei ebenfalls auf 77 K bevor er über die Transferleitung 20 wieder in die Kühlvorrichtung 1b gelangt, sich dort mit dem Gas aus dem Ventil 22 vermischt und dabei eine Temperatur von 55,8 K annimmt. Dieses Gas gelangt in den zweiten Stufentauscher 12, wird dort auf 35,8 K gekühlt und anschliessend in den Gegenstromtauscher 7 geführt. Von dort an verläuft alles wie bei Fig. 1. Das Ventil 24 dient dazu, den Gasfluss in der Kühlvorrichtung 1b auf den angenommenen Normfluss einzustellen.

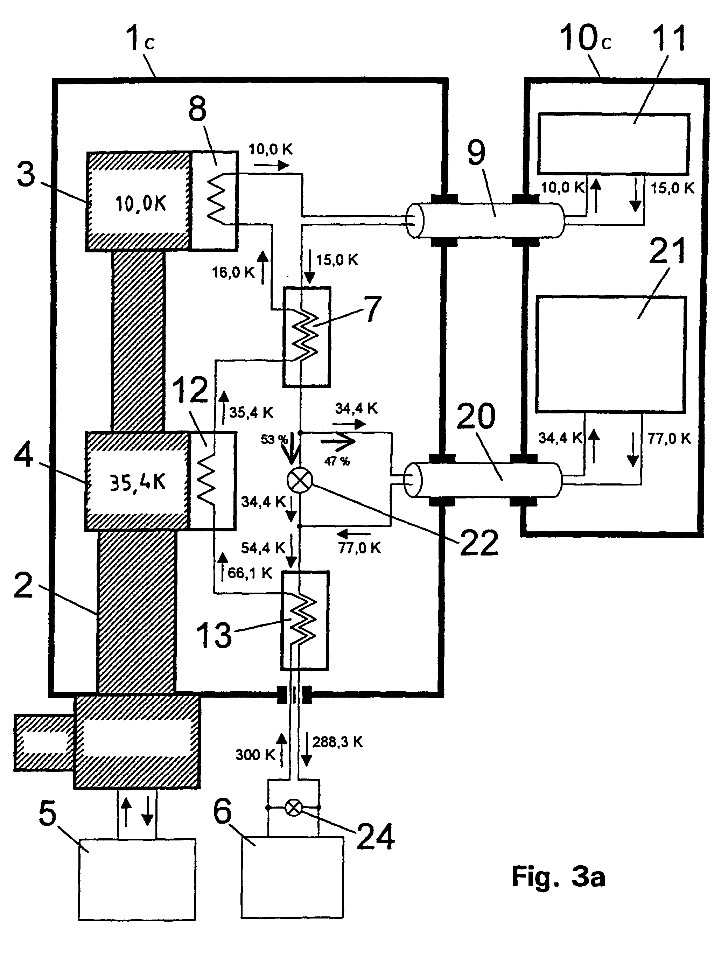

Die dritte Kühlvorrichtung liefert die besten Ergebnisse und ist in Fig. 3a dargestellt. Bei dieser Vorrichtung wird im Gasrücklauf die Verbindung vom Gegenstromtauscher 7 zum Gegenstromtauscher 13 unterbrochen und eine Kühlverbindung über die Transferleitung 20 zum Vorverstärker 21 hergestellt. Auf diese Weise wird der Stufentauscher 19 aus Fig. 2 nicht mehr benötigt. Diese Kühlvorrichtung kommt mit der geringsten Anzahl an Komponenten aus, liefert die besten Resultate im Vergleich zu den beiden anderen Vorschlägen und führt zudem zu einer Reduktion der Gesamtkosten.

Mit dem Ventil 22 lässt sich, ähnlich wie bei der Vorrichtung in Fig. 2, der Gasfluss zum Vorverstärker 21 so einstellen, dass der Vorverstärker 21 auf 77 K gekühlt wird. Die dazu benötigte Gasmenge beträgt 47 % des Gesamtflusses und hat eine Temperatur von 34,4 K. Dieses Gas erwärmt sich bei diesem Kühlvorgang von 34,4 K auf 77 K, fliesst über die Transferleitung 20 wieder zurück in die Kühlvorrichtung 1c, vermischt sich mit dem Gas aus dem Ventil 22, wobei es eine Temperatur von 54,4 K annimmt, und gelangt anschliessend zum Gegenstromtauscher 13 und dann zurück zur Pumpe 6.

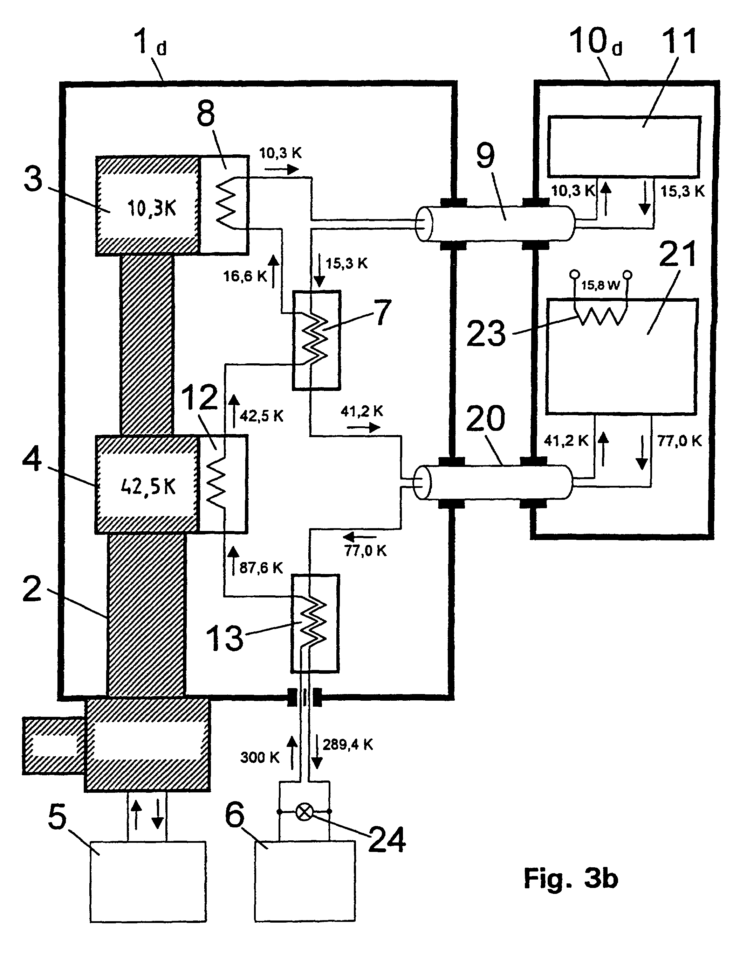

Grundsätzlich dient das Ventil 22 dazu, die Kühlleistung, die über das Heliumgas zum Vorverstärker 21 geführt wird, so einzustellen, dass die 20 W, die der Vorverstärker 21 erzeugt, abgeführt werden und die gewünschte Temperatur von 77 K erreicht wird. Man kann aber auch auf das Ventil verzichten und die volle Kühlleistung des Gases zum Vorverstärker 21 führen. Ohne Gegenmassnahmen würde sich der Vorverstärker 21 dadurch zu stark abkühlen und Temperaturen unterhalb 77 K erreichen. Dies kann aber vermieden werden, indem am Gehäuse des Vorverstärkers 21 ein Heizer 23 angebracht wird, mit dem der Vorverstärker wieder auf die gewünschte Temperatur von 77 K aufgeheizt werden kann. In Fig. 3b ist eine Kühlvorrichtung dargestellt, bei der ein solcher Heizer 23 eingesetzt wird. Der Heizer hat jedoch den Nachteil, dass die erste Stufe 4 des Cryo-Coolers 2 stärker belastet und dadurch auch die zweite Stufe 3 leicht beeinflusst wird. Die Temperatur am Ausgang des Stufentauschers 8 steigt deshalb von 10,0 K (siehe Fig. 3a) auf 10,3 K (siehe Fig. 3b) an.

Die Verwendung eines Heizers 23 ist nicht nur auf die erfindungsgemässe Anordnung in Fig. 3b beschränkt. Sie kann auch bei den beiden anderen erfindungsgemässen Anordnungen in den Figuren 1 und 2 eingesetzt werden.

Eine gewisse Reserve in der Kühlleistung für den Vorverstärker 21 ist natürlich vorteilhaft. Man kann die Grösse dieser Reserve mit einem Zahlenwert quantifizieren, indem man die maximale elektrische Verlustleistung ermittelt, die der Vorverstärker erzeugen dürfte, damit eine Kühlung auf 77 K gerade noch möglich ist. In der Tabelle ist diese maximale Verlustleistung sowohl für die Anordnung in Fig. 6 wie auch für die drei erfindungsgemässen Anordnungen in Fig. 1, Fig. 2 und Fig. 3a/3b aufgezeichnet.

Die Kühlvorrichtung gemäss Fig. 6 liefert die besten Zahlen, nämlich 42,5 W für die maximale Verlustleistung des Vorverstärkers und 14,6 K für die dazu geltende Temperatur der Empfangsspule. Diese Variante benötigt jedoch einen enormen Aufwand an Komponenten, nämlich zwei Cryo-Cooler, drei Stufentauscher und drei Gegenstromtauscher. Aus diesem Grunde ist sie sehr teuer und für kommerzielle Anwendungen wenig attraktiv.

Anders verhält es sich mit der neuen Kühlvorrichtung von Fig. 3a , die zwar ein wenig schlechtere Zahlenwerte liefert, nämlich 35,8 W für den Vorverstärker und 15,3 K für die Empfangsspule, aber mit viel weniger Aufwand an Komponenten auskommt, nämlich nur einem Cryo-Cooler, zwei Stufentauscher und zwei Gegenstromtauscher. Das Leistungs-Preis-Verhältnis darf in diesem Fall als hervorragend und die Attraktivität für kommerzielle Anwendungen als besonders hoch eingestuft werden.

Zum Schluss sei noch darauf hingewiesen, dass die erfindungsgemässen Kühlvorrichtungen von Fig. 1, Fig. 2 und Fig. 3a/3b auch dann noch funktionsfähig sind, wenn die Richtung des Gasflusses entgegengesetzt ist. Die Effizienz der Kühlung hingegen kann dadurch etwas schlechter werden.

| Kühlvorrichtung | Maximal erlaubte Verlustleistung $P_{max}$ des Vorverstärkers | Temperatur des Vorverstärkers (konstant) | Temperatur der Empfangsspule bei $P_{max}$ des Vorverstärkers |
|---|---|---|---|
| Fig. 6 | 42,5 W | 77 K | 14,6 K |
| Fig. 1 | 30,9 W | 77 K | 15,5 K |
| Fig. 2 | 34,3 W | 77 K | 15,3 K |
| Fig. 3a/3b | 35,8 W | 77 K | 15,3 K |

**Patentansprüche**

1. Messvorrichtung für Kernspinresonanz(NMR)-Messungen mit einem eine oder mehrere NMR-Empfangsspulen (11) enthaltenden NMR-Messkopf (10 a bis d), der über eine kryotechnisch isolierte Transferleitung (9) mit Kühlmittel aus einer Kühlvorrichtung (1 a bis d) versorgt werden kann, wobei die Kühlvorrichtung (1 a bis d) einen Cryo-Cooler (2) mit einer ersten Kühlstufe (4) mit einem ersten Stufentauscher (12) und mit einer zweiten Kühlstufe (3) mit einem zweiten Stufentauscher (8) aufweist, wobei eine Pumpe (6) vorgesehen ist, die in einem Kreislauf zunächst auf Zimmertemperatur befindliches Kühlmittel durch einen ersten Gegenstromtauscher (13), den ersten Stufentauscher (12), einen zweiten Gegenstromtauscher (7), den zweiten Stufentauscher (8) und die Transferleitung (9) in den NMR-Messkopf (10 a bis d) zur Kühlung der NMR-Empfangsspule(n) (11) und wieder zurück durch die Transferleitung (9), den zweiten Gegenstromtauscher (7) und den ersten Gegenstromtauscher (13) fördern kann,

   **dadurch gekennzeichnet,**

   **dass** im NMR-Messkopf (10 a bis d) zusätzlich zu der bzw. den NMR-Empfangsspulen (11) ein oder mehrere Vorverstärker (21) zur Verstärkung der mit den NMR-Empfangsspulen (11) empfangenen NMR-Signale vorhanden sind, dass eine weitere kryotechnisch isolierte Transferleitung (20) zwischen der Kühlvorrichtung (1 a bis d) und dem NMR-Messkopf (10 a bis d) vorgesehen ist, über die der bzw. die Vorverstärker (21) und/oder mit den Vorverstärkern (21) in Verbindung stehende Bauteile, z.B. Hochfrequenz(HF)-Schalter, HF-Filter, Befestigungselemente, mit einem Kühlmittelstrom versorgt werden, der sich auf einem höheren Temperaturniveau befindet, als der zur Kühlung der NMR-Empfangsspulen (11) eingesetzte Kühlmittelstrom,

   und **dass** zur Kühlung beider Kühlmittelströme ausschliesslich der Cryo-Cooler (2) und ggf. weitere Wärmetauscher vorgesehen sind.

2. Messvorrichtung nach Anspruch 1, **dadurch gekennzeichnet, dass** der erste Kühlmittelstrom unmittelbar nach Verlassen der NMR-Empfangsspulen (11) eine Temperatur unterhalb 20 K, vorzugsweise um 15 K, und der zweite Kühlmittelstrom unmittelbar nach Verlassen der Vorverstärker (21) eine Temperatur um 80 K, vorzugsweise etwa 77 K aufweist.

3. Messvorrichtung nach Anspruch 1 oder 2, **dadurch gekennzeichnet, dass** zwei getrennte Kühlkreisläufe zur Kühlung der NMR-Empfangsspulen (11) einerseits und zur Kühlung der Vorverstärker (21) und/oder damit in Verbindung stehender Bauteile andererseits vorgesehen sind.

**4.** Messvorrichtung nach Anspruch 3, **dadurch gekennzeichnet, dass** zusätzlich zum ersten Stufentauscher (12) ein weiterer Stufentauscher (19) an die erste Kühlstufe (4) des Cryo-Coolers (2) angeschlossen ist, wobei der erste Stufentauscher (12) zur Kühlung des Kühlmittelstroms im Kühlkreislauf der NMR-Empfangsspulen (1) und der weitere Stufentauscher im Kühlkreislauf der Vorverstärker (21) eingesetzt ist.

**5.** Messvorrichtung nach Anspruch 4, **dadurch gekennzeichnet, dass** ein weiterer Gegenstromtauscher (18) zwischen der Pumpe (6) und dem weiteren Stufentauscher (19) sowie der weiteren Transferleitung (20) in den Kühlkreislauf des Vorverstärkers (21) geschaltet ist.

**6.** Messvorrichtung nach einem der Ansprüche 3 bis 5, **dadurch gekennzeichnet, dass** in beiden Kühlkreisläufen jeweils mindestens ein auf ungefähr Raumtemperatur befindliches Ventil zur Steuerung der Massenflüsse des Kühlmittels vorgesehen ist.

**7.** Messvorrichtung nach Anspruch 1 oder 2, **dadurch gekennzeichnet, dass** lediglich ein einziger Kühlkreislauf mit zwei Teilströmen zur Kühlung der NMR-Empfangsspulen (11) einerseits und zur Kühlung der Vorverstärker (21) und/oder damit in Verbindung stehender Bauteile andererseits vorgesehen ist.

**8.** Messvorrichtung nach Anspruch 7, **dadurch gekennzeichnet, dass** ein gekühltes Ventil (22) zur Steuerung des Massenflusses des zu den Vorverstärkern (21) strömenden Kühlmittels vorgesehen ist.

**9.** Messvorrichtung nach Anspruch 7 oder 8, **dadurch gekennzeichnet, dass** zusätzlich zum ersten Stufentauscher (12) ein weiterer Stufentauscher (19) an die erste Kühlstufe (4) des Cryo-Coolers (2) angeschlossen ist, wobei der weitere Stufentauscher (19) zur Kühlung der Vorverstärker (21) und/oder damit in Verbindung stehender Bauteile und gegebenenfalls eines zum ersten Stufentauscher (12) direkt strömenden Teilstroms von Kühlmittel und der erste Stufentauscher (12) zur Kühlung des zu den NMR-Empfangsspulen (11) strömenden Kühlmittels eingesetzt ist.

**10.** Messvorrichtung nach Anspruch 7 oder 8, **dadurch gekennzeichnet, dass** ein Teilstrom des von den NMR-Empfangsspulen (11) über den zweiten Gegenstromtauscher (7) zurückströmenden Kühlmittels zur Kühlung der Vorverstärker (21) und/oder damit in Verbindung stehender Bauteile abgezweigt und anschliessend durch die weitere Transferleitung (20) und den ersten Gegenstromtauscher (13) zur Pumpe (6) zurückgeführt wird.

**11.** Messvorrichtung nach Anspruch 7, **dadurch gekennzeichnet, dass** der gesamte Kühlmittelstrom von den NMR-Empfangsspulen (11) über den zweiten Gegenstromtauscher (7) zur Kühlung der Vorverstärker (21) und/ oder damit in Verbindung stehender Bauteile und anschliessend durch die weitere Transferleitung (20) und den ersten Gegenstromtauscher (13) zur Pumpe (6) geführt wird.

**12.** Messvorrichtung nach einem der vorhergehenden Ansprüche, **dadurch gekennzeichnet, dass** in räumlicher Nähe der Vorverstärker (21) ein Heizer (23) vorgesehen ist.

**13.** Messvorrichtung nach einem der vorhergehenden Ansprüche, **dadurch gekennzeichnet, dass** eine gemeinsame kryotechnische Isolation um die erste Transferleitung (9) und die weitere Transferleitung (29) vorgesehen ist.

**Claims**

**1.** Measuring device for nuclear magnetic resonance (NMR) measurements, comprising an NMR measuring head (10a through d) which contains one or more NMR receiving coils (11) and can be supplied with cooling agent from a cooling device (1a through d) via a cryotechnically insulated transfer conduit (9), wherein the cooling device (1a through d) comprises a cryo-cooler (2) with a first cooling stage (4) with a first stage exchanger (12) and a second cooling stage (3) with a second stage exchanger (8), wherein a pump (6) is provided which can convey cooling agent, which is initially at room temperature, in a circuit through a first counter-flow exchanger (13), the first stage exchanger (12), a second counter-flow exchanger (7), the second stage exchanger (8) and the transfer conduit (9) into the NMR measuring head (10a through d) for cooling the NMR receiver coil(s) (11) and back through the transfer conduit (9), the second counter-flow exchanger (7) and the first counter-flow exchanger (13), **characterized in that**

one or more pre-amplifier(s) (21) is/are provided in the NMR measuring head (10a through d) in addition to the NMR receiver coil(s) (11) to amplify the NMR signals received by the NMR receiver coils (11), a further cryotechnically insulated transfer conduit (20) is provided between the cooling device (1a through d) and the NMR measuring head (10a through d), via which the pre-amplifier(s) (21) and/or components connected to the pre-amplifiers (21), e.g. radio frequency (RF) switches, RF filters, mounting elements, are supplied with a cooling agent flow which is at a higher temperature level than the cooling agent flow used for cooling the NMR receiver coils (11), and exclusively the cryo-cooler (2) and optionally further heat exchangers is/are provided for cooling both cooling agent flows.

2. Measuring device according to claim 1, **characterized in that** the first cooling agent flow has a temperature below 20K, preferably about 15 K, directly after leaving the NMR receiver coils (11), and the second cooling agent flow has a temperature of about 80K, preferably approximately 77K, directly after leaving the pre-amplifiers (21).

3. Measuring device according to claim 1 or 2, **characterized in that** two separate cooling circuits are provided, one for cooling the NMR receiver coils (11) and one for cooling the pre-amplifiers (21) and/or components connected thereto.

4. Measuring device according to claim 3, **characterized in that** a further stage exchanger (19) is connected to the first cooling stage (4) of the cryo-cooler (2) in addition to the first stage exchanger (12), wherein the first stage exchanger (12) is used to cool the cooling agent flow in the cooling circuit of the NMR receiver coils (1) and the further stage exchanger is used in the cooling circuit of the pre-amplifiers (21).

5. Measuring device according to claim 4, **characterized in that** a further counter-flow exchanger (18) is connected to the cooling circuit of the pre-amplifier (21) between the pump (6) and the further stage exchanger (19) and the further transfer conduit (20).

6. Measuring device according to any one of the claims 3 through 5, **characterized in that** at least one valve which is approximately at room temperature is provided each in both cooling circuits for controlling the mass flows of the cooling agent.

7. Measuring device according to claim 1 or 2, **characterized in that** only one single cooling circuit with two partial flows is provided for cooling the NMR receiver coils (11) as well as for cooling the pre-amplifiers (21) and/or components which are connected thereto.

8. Measuring device according to claim 7, **characterized in that** a cooled valve (22) is provided for controlling the mass flow of the cooling agent flowing to the pre-amplifiers (21).

9. Measuring device according to claim 7 or 8, **characterized in that**, in addition to the first stage exchanger (12), a further stage exchanger (19) is connected to the first cooling stage (4) of the cryo-cooler (2), wherein the further stage exchanger (19) is used for cooling the pre-amplifiers (21) and/or components connected thereto, and optionally, for cooling a partial cooling agent flow which flows directly to the first stage exchanger (12), and the first stage exchanger (12) is used to cool the cooling agent flowing to the NMR receiver coils (11).

10. Measuring device according to claim 7 or 8, **characterized in that** a partial flow of the cooling agent which flows back from the NMR receiver coils (11) via the second counter-flow exchanger (7) is branched off for cooling the pre-amplifiers (21) and/or components connected thereto, and is subsequently guided back to the pump (6) through the further transfer conduit (20) and the first counter-flow exchanger (13).

11. Measuring device according to claim 7, **characterized in that** the entire cooling agent flow is guided by the NMR receiver coils (11) via the second counter-flow exchanger (7), for cooling the pre-amplifiers (21) and/or components connected thereto, and subsequently to the pump (6) trough the further transfer conduit (20) and the first counter-flow exchanger (13).

12. Measuring device according to any one of the preceding claims, **characterized in that** a heater (23) is provided in the vicinity of the pre-amplifiers (21).

13. Measuring device according to any one of the preceding claims, **characterized in that** a common cryotechnical insulation is provided about the first transfer conduit (9) and the further transfer conduit (29).

## Revendications

1. Dispositif de mesure pour mesures par résonance magnétique nucléaire (RMN) avec une tête de mesure RMN (10 a à d) contenant une ou plusieurs bobine(s) de réception RMN (11), laquelle peut être alimentée en liquide de refroidissement à partir d'un dispositif de refroidissement (1 a à d) par une canalisation de transfert cryotechniquement isolée (9), dans lequel le dispositif de refroidissement (1 a à d) présente un cryorefroidisseur (2) avec un premier étage de refroidissement (4) comprenant un premier échangeur d'étage (12) et avec un deuxième étage de refroidissement (3) comprenant un deuxième échangeur d'étage (8), dans lequel il est prévu une pompe (6) qui peut refouler dans un circuit du liquide de refroidissement se trouvant d'abord à température ambiante à travers un premier échangeur à contre-courant (13), le premier échangeur d'étage (12), un deuxième échangeur à contre-courant (7), le deuxième échangeur d'étage (8) et la canalisation de transfert (9) dans la tête de mesure RMN (10 a à d) pour refroidir la ou les bobine(s) de réception RMN (11) et de nouveau en retour à travers la canalisation de transfert (9), le deuxième échangeur à contre-courant (7) et le premier échangeur à contre-courant (13), **caractérisé par le fait**

   **qu'**il existe dans la tête de mesure RMN (10 a à d) en plus de la ou les bobine(s) de réception RMN (11) un ou plusieurs préamplificateur(s) (21) pour amplifier les signaux RMN reçus par les bobines de réception RMN (11), qu'il est prévu une autre canalisation de transfert cryotechniquement isolée (20) entre le dispositif de refroidissement (1 a à d) et la tête de mesure RMN (10 a à d) par l'intermédiaire de laquelle le ou les préamplificateur(s) (21) et/ou des composants en liaison avec les préamplificateurs (21), p. ex. des commutateurs haute fréquence (HF), des filtres HF, des éléments de fixation, sont alimentés par un flux de liquide de refroidissement qui se trouve à un niveau de température plus élevé que le flux de liquide de refroidissement utilisé pour refroidir les bobines de réception RMN (11),

   et **qu'**il est prévu pour le refroidissement des deux flux de liquide de refroidissement exclusivement le cryorefroidisseur (2) et, le cas échéant, d'autres échangeurs de chaleur.

2. Dispositif de mesure selon la revendication 1, **caractérisé par le fait que** le premier flux de liquide de refroidissement présente immédiatement après avoir quitté les bobines de réception RMN (11) une température inférieure à 20 K, de préférence autour de 15 K, et que le deuxième flux de liquide de refroidissement présente immédiatement après avoir quitté les préamplificateurs (21) une température autour de 80 K, de préférence à peu près 77 K.

3. Dispositif de mesure selon la revendication 1 ou 2, **caractérisé par le fait qu'**il est prévu deux circuits de refroidissement séparés pour refroidir les bobines de réception RMN (11) d'une part et pour refroidir les préamplificateurs (21) et/ou des composants en liaison avec eux d'autre part.

4. Dispositif de mesure selon la revendication 3, **caractérisé par le fait qu'**en plus du premier échangeur d'étage (12) un autre échangeur d'étage (19) est relié au premier étage de refroidissement (4) du cryorefroidisseur (2), le premier échangeur d'étage (12) étant utilisé pour refroidir le flux de liquide de refroidissement dans le circuit de refroidissement des bobines de réception RMN (11) et l'autre échangeur d'étage dans le circuit de refroidissement des préamplificateurs (21).

5. Dispositif de mesure selon la revendication 4, **caractérisé par le fait qu'**un autre échangeur à contre-courant (18) est intercalé entre la pompe (6) et l'autre échangeur d'étage (19) ainsi que l'autre canalisation de transfert (20) dans le circuit de refroidissement des préamplificateurs (21).

6. Dispositif de mesure selon l'une des revendications 3 à 5, **caractérisé par le fait qu'**il est prévu dans chacun des deux circuits de refroidissement au moins une vanne se trouvant à peu près à température ambiante pour la commande des flux massiques du liquide de refroidissement.

7. Dispositif de mesure selon la revendication 1 ou 2, **caractérisé par le fait qu'**il est prévu un seul circuit de refroidissement avec deux flux partiels pour refroidir les bobines de réception RMN (11) d'une part et refroidir les préamplificateurs (21) et/ou des composants en liaison avec eux d'autre part.

8. Dispositif de mesure selon la revendication 7, **caractérisé par le fait qu'**il est prévu une vanne refroidie (22) pour la commande du flux massique du liquide de refroidissement allant aux préamplificateurs (21).

9. Dispositif de mesure selon la revendication 7 ou 8, **caractérisé par le fait qu'**en plus du premier échangeur d'étage (12) un autre échangeur d'étage (19) est relié au premier étage de refroidissement (4) du cryorefroidisseur (2), l'autre échangeur d'étage (19) étant utilisé pour refroidir les préamplificateurs (21) et/ou des composants en liaison avec eux et le cas échéant un flux partiel de liquide de refroidissement allant directement au premier échangeur d'étage (12) et le premier échangeur d'étage (12) étant utilisé pour refroidir le liquide de refroidissement allant aux bobines de réception RMN (11).

10. Dispositif de mesure selon la revendication 7 ou 8, **caractérisé par le fait qu'**un flux partiel du liquide de refroidissement revenant des bobines de réception RMN (11) par le deuxième échangeur à contre-courant (7) est dérivé pour refroidir les préamplificateurs (21) et/ou des composants en liaison avec eux, puis ramené à la pompe (6) par l'autre canalisation de transfert (20) et le premier échangeur à contre-courant (13).

11. Dispositif de mesure selon la revendication 7, **caractérisé par le fait que** la totalité du flux de liquide de refroidissement est amenée des bobines de réception RMN (11) à la pompe (6) par le deuxième échangeur à contre-courant (7) pour refroidir les préamplificateurs (21) et/ou des composants en liaison avec eux et ensuite à travers le premier échangeur à contre-courant (13).

12. Dispositif de mesure selon l'une des revendications précédentes, **caractérisé par le fait qu'**il est prévu un élément chauffant (23) à proximité physique des préamplificateurs (21).

13. Dispositif de mesure selon l'une des revendications précédentes, **caractérisé par le fait qu'**il est prévu une isolation cryotechnique commune autour de la première canalisation de transfert (9) et de l'autre canalisation de transfert (20).

Fig. 1

Fig. 2

**Fig. 3a**

**Fig. 3b**

**Fig. 4**

**Fig. 5**

Fig. 6